# EUROPEAN PATENT APPLICATION

(11) **EP 4 273 924 A2**
(43) Date of publication of application: **08.11.2023**
(21) Application number: 23169755.8
(22) Date of filing: 25.04.2023
(51) Int. Cl.: H01L 23/48, H01L 23/528, H01L 25/065

(54) **CONNECTION SCHEME WITH BACKSIDE POWER DISTRIBUTION NETWORK**

(30) Priority: 02.05.2022 US 202263337549 P; 29.06.2022 US 202217853867; 21.03.2023 KR 20230036927
(71) Applicant: Samsung Electronics Co., Ltd., Suwon-si, Gyeonggi-do 16677 (KR)
(72) Inventor: PARK, Saehan, San Jose, CA, 95134 (US); LEE, Seungyoung, San Jose, CA, 95134 (US); SEO, Kangill, San Jose, CA, 95134 (US)
(74) Representative: Kuhnen & Wacker Patent- und Rechtsanwaltsbüro PartG mbB

(57) **Abstract**

Provided is a system (1) for routing connections to a logic circuit, the system including a first wafer (100) having a backside (120) and a frontside (110) opposite the backside (120), a power conductor (210) at the backside of the first wafer (100), a core (600) at the frontside (110) of the first wafer (100), a power via (300) electrically connected to the power conductor (210) and to the core (600), a signal pad (400) at the backside (120) of the first wafer (100), a first frontside signal-routing metal (112a) at the frontside (110) of the first wafer (100), and a signal via (400) connected to the signal pad (510) and the first frontside signal-routing metal (112a).

## Description

### Field

One or more aspects of one or more embodiments according to the present disclosure relate to systems and methods for providing power and signal connections within an integrated circuit.

### BACKGROUND

The present background section is intended to provide context only, and the disclosure of any embodiment or concept in this section does not constitute an admission that said embodiment or concept is prior art.

In the field of integrated circuits (ICs), power supply (e.g., voltage supply) and signal connections may be provided from the outside of an IC to the inside of the IC (e.g., to a core area of the IC) through a package (e.g., a package substrate) of the IC.

The core area of the IC may include a core, which includes logic cells (e.g., logic circuit components, such as transistors) for performing the functions of the integrated circuit. The core may be built, or formed, on a wafer (e.g., a silicon (Si) substrate).

A side of the wafer on which the core is built may be called a "frontside" of the wafer, and a side of the wafer that is opposite to the frontside of the wafer in a thickness direction of the wafer may be called a "backside" of the wafer. On the frontside of the wafer, there may be many power supply conductors (for providing power) and signal conductors (for providing signals) that are supplied from the package to the core, which may cause congestion (e.g., signal-routing congestion).

Accordingly, there may be systems, methods, and devices that are suitable for reducing congestion of conductors in integrated circuits.

### SUMMARY

Aspects of one or more embodiments of the present disclosure relate to integrated circuits, and provide improvements to power and/or signal routing.

According to one or more embodiments of the present disclosure, there is provided a system for routing connections to a logic circuit, the system including a first wafer having a backside and a frontside opposite the backside, a power conductor at the backside of the first wafer, a core at the frontside of the first wafer, a power via electrically connected to the power conductor and to the core, a signal pad at the backside of the first wafer, a first frontside signal-routing metal at the frontside of the first wafer, and a signal via connected to the signal pad and the first frontside signal-routing metal.

A height or a width of the signal via may be respectively larger than a height or a width of the power via.

The signal via may be substantially a same size as the power via.

The system may further include a second wafer at the frontside of the first wafer, and located above the core.

The system may further include a package at the backside of the first wafer.

The system may further include a pad area at the backside of the first wafer.

The pad area may include a first pad area including a supply voltage pad and a first signal pad, and a second pad area including a second signal pad.

The system may further include a power distribution network at the backside of the first wafer, and including the power conductor, and a conductive path configured to route a supply voltage from the package to the supply voltage pad, from the supply voltage pad to the power distribution network, and from the power distribution network to the core.

The system may further include a conductive path configured to route a signal from the package to the first signal pad, from the first signal pad to the first frontside signal-routing metal, and from the first frontside signal-routing metal to the core.

The system may further include a conductive path configured to route a signal from the core to a second frontside signal-routing metal, from the second frontside signal- routing metal to the second signal pad, and from the second signal pad to the package.

According to one or more other embodiments of the present disclosure, there is provided a method of manufacturing an integrated circuit, the method including connecting a power via to a power conductor at a backside of a first wafer, and to a core at a frontside of the first wafer, and connecting a signal via to a signal pad at the backside of the first wafer, and to a signal-routing metal at the frontside of the first wafer.

The method may further include forming the signal via on the first wafer to have a height or a width that is respectively larger than a height or a width of the power via.

The method may further include forming the signal via on the first wafer to have substantially a same size as the power via.

The method may further include bonding a second wafer above a frontside metal at the frontside of the first wafer.

The method may further include flipping the first wafer to position the backside of the first wafer above the frontside of the first wafer, and building a pad area at the backside of the first wafer.

The method may further include building a supply voltage pad and a signal pad in the pad area.

The method may further include connecting the supply voltage pad to a power distribution network at the backside of the first wafer, the power distribution network including the power conductor, and connecting the signal pad to the signal via.

The method may further include bonding a package to a backside metal at the backside of the first wafer.

The backside metal may be connected to a supply voltage pad or a signal pad at the backside of the first wafer.

According to one or more other embodiments of the present disclosure, there is provided an integrated circuit, including a first wafer having a backside and a frontside, a core at the frontside of the first wafer, a power distribution network at the backside of the first wafer, and connected to the core, a frontside signal-routing metal at the frontside of the first wafer, and a signal pad at the backside of the first wafer, and connected to the frontside signal-routing metal.

### BRIEF DESCRIPTION OF THE DRAWINGS

Non-limiting and non-exhaustive embodiments of the present disclosure are described with reference to the following figures, wherein like reference numerals refer to like parts throughout the various views unless otherwise specified.
FIG. 1 is a system diagram depicting a Power Distribution Network (PDN)-to-core connection scheme with a backside power distribution network (BSPDN), according to one or more embodiments of the present disclosure;
FIG. 2 is a system diagram depicting a power and signal connection scheme with a BSPDN, according to one or more embodiments of the present disclosure;
FIG. 3 (including FIGS. 3A to 3F) is a process diagram depicting operations of a method of manufacturing an integrated circuit with differing power via structures and signal via structures, according to one or more embodiments of the present disclosure;
FIG. 4 (including FIGS. 4A to 4F) is a process diagram depicting operations of a method of manufacturing an integrated circuit with power via structures and signal via structures that are substantially the same as each other (e.g., "small" signal IO vias are used instead of "large" signal IO vias), according to one or more embodiments of the present disclosure; and
FIG. 5 is a flowchart depicting operations of a method of manufacturing an integrated circuit, according to one or more embodiments of the present disclosure.

Corresponding reference characters indicate corresponding components throughout the several views of the drawings. Skilled artisans will appreciate that elements in the figures are illustrated for simplicity and clarity, and have not necessarily been drawn to scale. For example, the dimensions of some of the elements, layers, and regions in the figures may be exaggerated relative to other elements, layers, and regions to help to improve clarity and understanding of various embodiments. Also, common but well- understood elements and parts not related to the description of the embodiments might not be shown in order to facilitate a less obstructed view of these various embodiments and to make the description clear.

### DETAILED DESCRIPTION

Aspects of the present disclosure and methods of accomplishing the same may be understood more readily by reference to the detailed description of one or more embodiments and the accompanying drawings. Hereinafter, embodiments will be described in more detail with reference to the accompanying drawings. The described embodiments, however, may be embodied in various different forms, and should not be construed as being limited to only the illustrated embodiments herein. Rather, these embodiments are provided as examples so that this disclosure will be thorough and complete, and will fully convey aspects of the present disclosure to those skilled in the art. Accordingly, description of processes, elements, and techniques that are not necessary to those having ordinary skill in the art for a complete understanding of the aspects and features of the present disclosure may be omitted.

Unless otherwise noted, like reference numerals, characters, or combinations thereof denote like elements throughout the attached drawings and the written description, and thus, descriptions thereof will not be repeated. Further, parts not related to the description of the embodiments might not be shown to make the description clear. In the drawings, the relative sizes of elements, layers, and regions may be exaggerated for clarity.

In the detailed description, for the purposes of explanation, numerous specific details are set forth to provide a thorough understanding of various embodiments. It is apparent, however, that various embodiments may be practiced without these specific details or with one or more equivalent arrangements.

It will be understood that, although the terms "zeroth," "first," "second," "third," etc., may be used herein to describe various elements, components, regions, layers and/or sections, these elements, components, regions, layers and/or sections should not be limited by these terms. These terms are used to distinguish one element, component, region, layer or section from another element, component, region, layer or section. Thus, a first element, component, region, layer or section described below could be termed a second element, component, region, layer or section, without departing from the scope of the present disclosure.

It will be understood that when an element or component is referred to as being "on," "connected to," or "coupled to" another element or component, it can be directly on, connected to, or coupled to the other element or component, or one or more intervening elements or components may be present. However, "directly connected/directly coupled" refers to one component directly connecting or coupling another component without an intermediate component. Meanwhile, other expressions describing relationships between components such as "between," "immediately between" or "adjacent to" and "directly adjacent to" may be construed similarly. In addition, it will also be understood that when an element or component is referred to as being "between" two elements or components, it can be the only element or component between the two elements or components, or one or more intervening elements or components may also be present.

**The** terminology used herein is for the purpose of describing particular embodiments only and is not intended to be limiting of the present disclosure. As used herein, the singular forms "a" and "an" are intended to include the plural forms as well, unless the context clearly indicates otherwise. It will be further understood that the terms "comprises," "comprising," "have," "having," "includes," and "including," when used in this specification, specify the presence of the stated features, integers, steps, operations, elements, and/or components, but do not preclude the presence or addition of one or more other features, integers, steps, operations, elements, components, and/or groups thereof. As used herein, each of the terms "or" and "and/or" includes any and all combinations of one or more of the associated listed items.

As used herein, the term "substantially," "about," "approximately," and similar terms are used as terms of approximation and not as terms of degree, and are intended to account for the inherent deviations in measured or calculated values that would be recognized by those of ordinary skill in the art. "About" or "approximately," as used herein, is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" may mean within one or more standard deviations, or within ± 30%, 20%, 10%, 5% of the stated value. Further, the use of "may" when describing embodiments of the present disclosure refers to "one or more embodiments of the present disclosure."

When one or more embodiments may be implemented differently, a specific process order may be performed differently from the described order. For example, two consecutively described processes may be performed substantially at the same time or performed in an order opposite to the described order.

Any of the components or any combination of the components described (e.g., in any system diagrams included herein) may be used to perform one or more of the operations of any flow chart included herein. Further, (i) the operations are merely examples, and may involve various additional operations not explicitly covered, and (ii) the temporal order of the operations may be varied.

Unless otherwise defined, all terms (including technical and scientific terms) used herein have the same meaning as commonly understood by one of ordinary skill in the art to which the present disclosure belongs. It will be further understood that terms, such as those defined in commonly used dictionaries, should be interpreted as having a meaning that is consistent with their meaning in the context of the relevant art and/or the present specification, and should not be interpreted in an idealized or overly formal sense, unless expressly so defined herein.

**As** mentioned above, in the field of integrated circuits (ICs), power supply (e.g., voltage supply) and signal connections may be provided from an exterior of an IC to an interior of the IC through a package (e.g., a package substrate) of the IC, and then may be provided to a core area of the IC.

The IC may be a central processing unit (CPU) or an application processor (AP) chip, or the like. The IC may be a chip used in mobile communications devices. The IC may have multiple internal power and signal connections.

The core area may include a core. The core may include logic cells for performing the functions of the integrated circuit. The logic cells may comprise logic circuit components, such as transistors. The core may be built or formed on a wafer or substrate.

A side of the wafer on which the core is built may be called a "frontside" of the wafer, and an opposite side of the wafer (e.g., with respect to a thickness direction of the wafer) may be called a "backside" of the wafer. On the frontside of the wafer, there may be multiple power supply conductors and signal conductors routed from (e.g., extending from) the package to the core. Congestion (e.g., routing congestion) may occur at the power supply conductors and the signal conductors.

For example, in conventional system level connection schemes, the package and a pad may be placed only on the frontside of the wafer. The pad may include power supply and signal connections provided at a periphery of the core. The power connections and signal connections extending from the package to the core may be provided by frontside metal layers (e.g., frontside metals). However, routing all of the power and signal connections to the core via the frontside metals may lead to routing congestion as a number of power and signal connections increases.

To reduce congestion at the frontside of the wafer, a backside power distribution network (BSPDN) scheme may be implemented. In a BSPDN, the power distribution network is located at the backside of the wafer, as opposed to at the frontside of the wafer. To implement a BSPDN scheme, novel pad to core interconnection schemes, and pad and package placement schemes, may be part of a fully integrated circuit system.

In one or more embodiments, a BSPDN may be provided by locating a power distribution network (PDN) at a wafer backside. Frontside and backside connections may be made by way of a buried power rail and through silicon via (BPR/TSV), or by way of a power via.

In one or more embodiments, a PDN, pads, and a package may be located on the backside of the wafer. Further, a power via may be located in the wafer to deliver power from the PDN on the backside of the wafer to devices in the core area on the frontside of the wafer. In one or more embodiments, a signal input/output through silicon via (IO TSV) (or small via option) and frontside metals may be used for IO signal connection between IO pads on the backside of the wafer and the frontside core area.

Accordingly, aspects of one or more embodiments of the present disclosure allow for reduced routing congestion and for area scaling. For example, routing congestion between signal routing and power routing caused by placement of a PDN on a frontside of the wafer may be reduced by placing the PDN to the backside of the wafer. Placing the PDN at the backside of the wafer may achieve an area reduction (e.g., about a 10% to 30% area reduction, depending upon applied conditions) and an IR drop (e.g., a voltage drop due to current and resistance) improvement, as compared to conventional PDN schemes. For example, a resistance of the system may be reduced by simplifying PDN layers (e.g., by forming the PDN layers with less metal), thereby resulting in a lower IR drop across the PDN. Furthermore, because less metal may be used in a BSPDN scheme, manufacturing costs may be reduced.

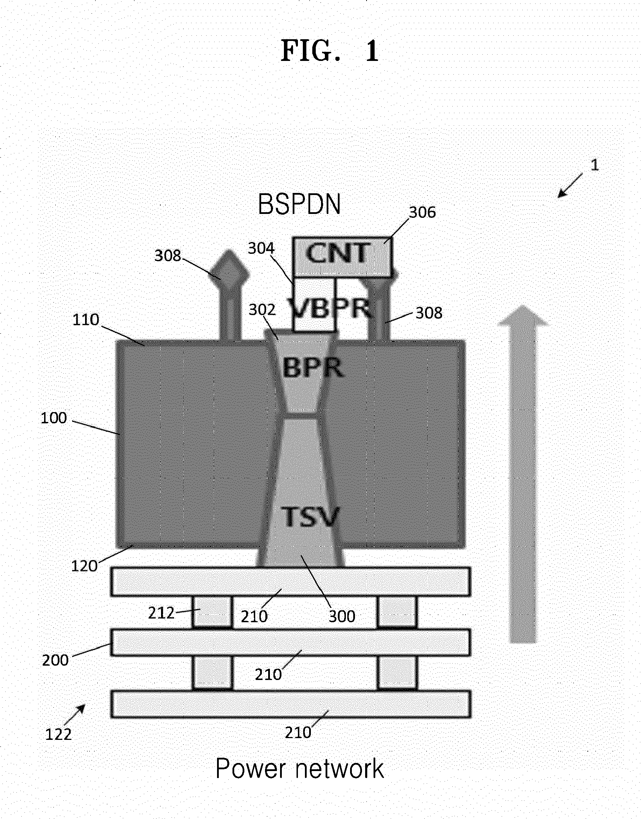

FIG. 1 is a system diagram depicting a Power Distribution Network (PDN)-to-core connection scheme with a BSPDN, according to one or more embodiments of the present disclosure.

Referring to FIG. 1, a system 1 for routing connections to a logic circuit 308 may include a wafer 100. The wafer 100 may be a Si substrate on which the logic circuit 308 is built. The wafer 100 may have a frontside 110 and a backside 120 opposite the front side 110. The logic circuit 308 may be located at the frontside 110 of the wafer 100.

**A** PDN 200 may be located at the backside 120 of the wafer 100. For example, the PDN 200 may be a backside PDN. The PDN 200 may be composed of backside metals 122. The backside metals 122 may include power conductors 210 (e.g., power rails). In one or more embodiments, backside metals 122 and power conductors (e.g., power rails) 210 may be connected to each other through vias 212.

The PDN 200 may be connected to the logic circuit 308 through one or more other components. In one or more embodiments, the PDN 200 may be connected to the logic circuit 308 by conventional means, such as through a combination of the following components: a power via 300 (e.g., a through silicon via (TSV)), a buried power rail (BPR) 302, a buried power rail via (VBPR) 304, and a contact 306. For example, in one or more embodiments, the power via 300 may not extend through an entire depth of the wafer 100 (e.g., a length of the power via 300 may be less than a depth of the wafer 100).

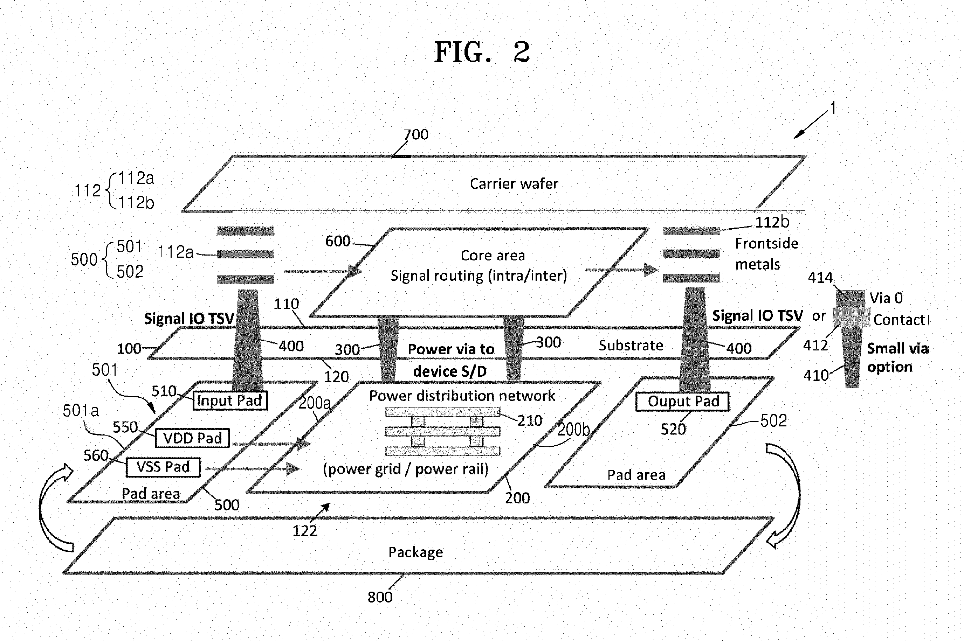

FIG. 2 is a system diagram depicting a power connection and signal connection scheme with a BSPDN, according to one or more embodiments of the present disclosure.

Referring to FIG. 2, the system 1 may include frontside metals 112 at the frontside 110 of the wafer 100, and backside metals 122 at the backside 120 of the wafer 100. The frontside metals 112 may enable signal routing. The backside metals 122 may include the PDN 200. In one or more embodiments, the PDN 200 may include power conductors 210. In one or more embodiments, the power conductors 210 may include a first backside metal line that is utilized as a power rail.

The system 1 may also include pads. The pads may include an input pad 510, an output pad 520, a first supply voltage pad 550, and a second supply voltage pad 560. The input pad 510 may be a first signal pad. Hereinafter, the mentioned input pad 510 may be an input pad configured to input a signal. In addition, the output pad 520 may be a second signal pad. Hereinafter, the aforementioned output pad 520 may be an output pad configured to output a signal.

The pads may be located in pad areas 500. The pad areas 500 may include a first pad area 501 and a second pad area 502 disposed on both sides of the PDN 200 with the PDN 200 interposed therebetween. In one or more embodiments, the pad areas 500 may be located at the backside 120. The system 1 may also include a package 800 (e.g., a package substrate) at the backside 120. The relative locations of the input pad 510, the output pad 520, the first supply voltage pad 550, and the second supply voltage pad 560 may allow for reduced routing congestion. For example, in one or more embodiments, the input pad 510 may be located at a first end of a first pad area 501 (the first pad area 501 may be referred to as an "input" pad area). In one or more embodiments, the output pad 520 may be located at a first end of a second pad area 502 (the second pad area 502 may be referred to as an "output" pad area). The first pad area 501 may be located at a first end 200a of the PDN 200, and the second pad area 502 may be located at a second end 200b of the PDN 200. The first and second ends 200a, 200b of the PDN 200 may refer to opposite ends of the PDN 200 in a lateral direction. The pad areas 500 may be separate and distinct from the PDN 200. For example, the pad areas 500 and the PDN 200 may be formed as separate and distinct structures. In one or more embodiments, the first supply voltage pad 550 and the second supply voltage pad 560 may be located toward (e.g., located at) a second end 501b of the first pad area 501, relative to the location of the input pad 510. The first and second ends 501a, 501b of the first pad area 501 may refer to opposite ends of the first pad area 501. In one or more embodiments, the first supply voltage pad 550 may be coupled to a VDD side (e.g., a positive side) of a power supply, and the second supply voltage pad 560 may be coupled to a VSS side (e.g., a negative side) of a power supply.

Power vias 300 and signal IO vias 400 may be located in the wafer 100. The power vias 300 and the signal IO vias 400 may enable connections between components of the frontside 110 and components of the backside 120. In one or more embodiments, the power vias 300 may extend through an entire depth of the wafer 100 (e.g., a length of the power via 300 may be greater than a depth, in a thickness direction, of the wafer 100). In one or more embodiments, the signal IO vias 400 may extend through an entire depth of the wafer 100 (e.g., a length of the signal IO vias 400 may be greater than a depth, in the thickness direction, of the wafer 100).

Power may be distributed through the backside metals 122 and through the power vias 300 to devices in a core area 600 on the frontside 110. Signal input and output (IO) lines (e.g., conductors) may be connected to the devices in the core area 600 on the frontside 110 through the signal IO vias 400 (e.g., TSVs or small vias). The signal IO vias 400 may be located between the input pad 510 at the backside 120 and the frontside metals 112. The signal IO vias 400 may also be located between the output pad 520 at the backside 120 and the frontside metals 112.

For example, in one or more embodiments, signals may be transferred from the backside 120 to the frontside 110 through a signal IO via 400. The signal IO via 400 may have a height or a width that is respectively larger than a height or a width of the power vias 300. The dimensions of the signal IO via 400 may provide a relatively more reduced IR drop due to having a lower resistance than a smaller via would have. However, according to another embodiment, the signal IO via 400 may have substantially the same height or width as the height or width of the power via 300.

In one or more embodiments, signals may be transferred from the backside 120 to the frontside 110 through a small signal IO via 410. The small signal IO via 410 may have the same height as the power vias 300. For example, the same structures used for power vias 300 may also be used for signal vias to simplify the manufacturing process and reduce costs. In embodiments using the small signal IO via 410, a contact 412 and a contact via 414 may connect the small signal IO via 410 to the frontside metals 112. The system 1 may include a carrier wafer 700 to provide mechanical stability for the chip during and after fabrication. The carrier wafer 700 may be located at the frontside 110, and may be bonded above frontside metal layers.

Accordingly, the system 1 may include a conductive path configured to route a supply voltage from the package 800 to a pad in the pad area 500, to the PDN 200, and to the core area 600 (e.g., to a core including a logic circuit in the core area 600). The front metal 112 may include a first front signal routing metal 112a and a second front signal routing metal 112b disposed on both sides of the core region 600 with the core region 600 interposed therebetween. The system 1 may include a conductive path configured to route a signal (e.g., an input signal) from the package 800 to the pad area 500 (e.g., an input pad 510), to the first and second frontside signal-routing metals 112a, 112b, and to the core area 600 (e.g., to the core including the logic circuit in the core area 600). The system 1 may include a conductive path configured to route a signal (e.g., an output signal) from the core to the first and second frontside signal-routing metals 112a, 112b, to the pad area 500 (e.g., to an output pad 520), and to the package 800.

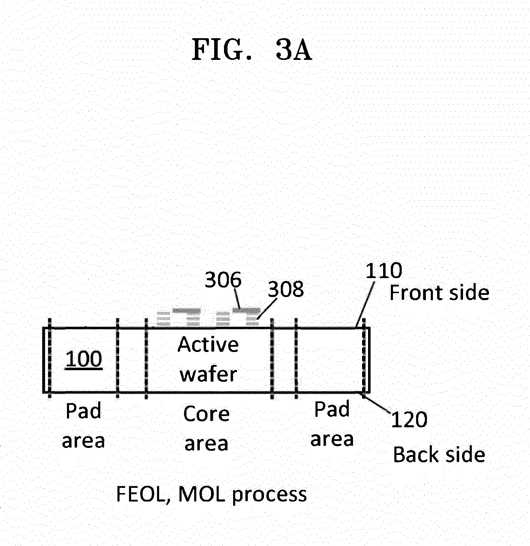

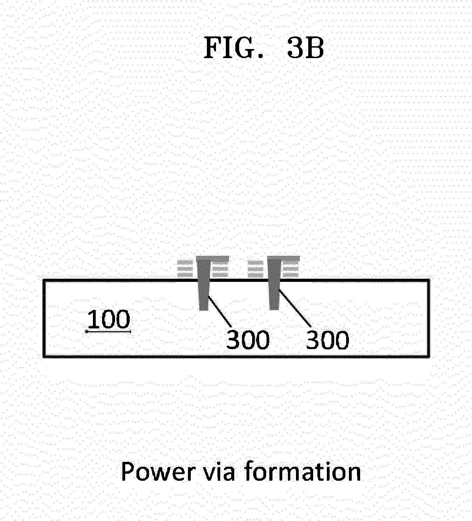

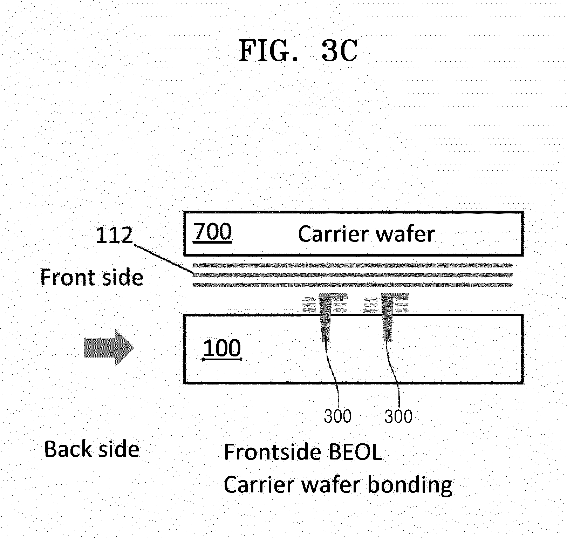

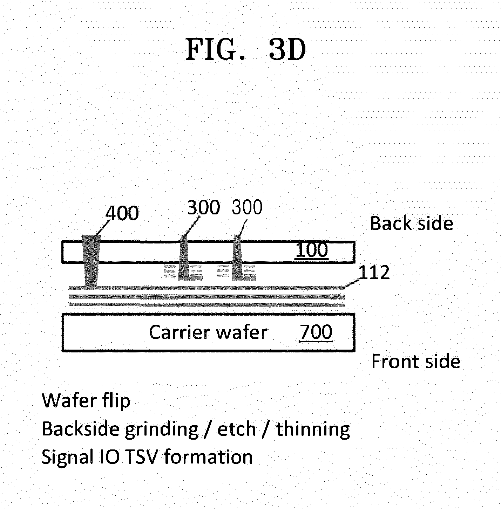

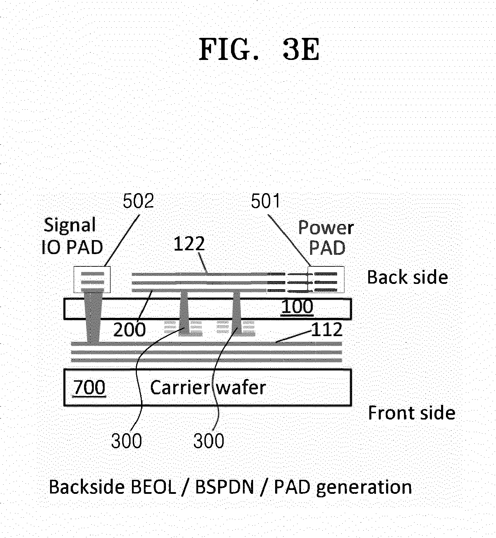

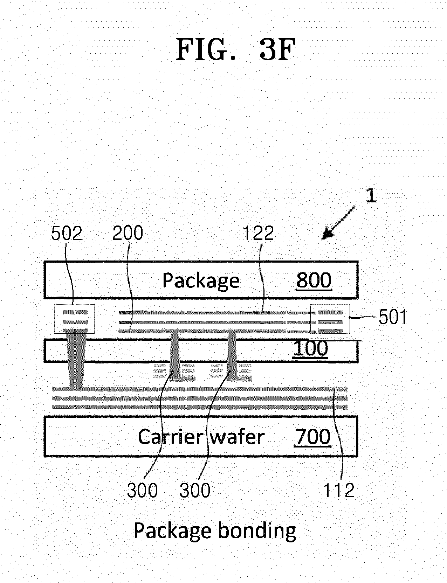

FIG. 3 (including FIGS. 3A to 3F) is a process diagram depicting operations of a method of manufacturing an integrated circuit with differing power via structures and signal via structures, according to one or more embodiments of the present disclosure.

Referring to FIG. 3A, a wafer 100 (e.g., an active wafer) may be positioned such that a frontside 110 of the wafer 100 is on top of, or above, a backside 120 of the wafer 100. A logic circuit 308 (e.g., a circuit including a transistor) and a contact 306 may be built on, or formed on, the frontside 110 by performing a front-end-of-line (FEOL) process and a middle-of-line-contact process (MOL-contact process).

Referring to FIG. 3B, a power via 300 may be built on, or formed on, the wafer 100 for making power distribution network (PDN) connections at the frontside 110 and the backside 120.

Referring to FIG. 3C, frontside metals 112 may be formed at the frontside 110 by performing a frontside-backend-of-the-line process (BEOL process). Further, a carrier wafer 700 may be bonded to the frontside metals 112 above the wafer 100.

Referring to FIG. 3D, the carrier wafer 700 may be flipped to position the wafer 100 with the backside 120 on top of, or above, the frontside 110 thereof. The backside 120 of the wafer 100 may be prepared for further processing by performing a backside grinding, an etching, and/or a thinning process(es) to expose the power via 300. A signal IO via 400 may be built on, or formed on, the wafer 100 after the thinning process.

Referring to FIG. 3E, a backside BEOL/BSPDN/pad generation process may be performed. The voltage supply pad and the signal pad may be formed in the first and second pad areas 501 and 502. In one or more embodiments, the BSPDN and the first and second pad areas 501, 502 may be formed as separate and distinct structures on the backside 120. In one or more embodiments, the BSPDN and the pad areas may be formed at a same level on the backside 120. For example (and as also shown in FIG. 2), a surface of the PDN 200 may be substantially co-planar with a surface of the pad areas 500. In one or more embodiments, backside metals 122 may be built on, or formed on, the backside 120. Further, connections may be made between the backside metals 122 and their respective vias. For example, a power pad in a pad area 500 on the backside 120 may be connected to the logic circuit 308 on the frontside 110 through the power via 300. Also, a signal IO pad in the pad area 500 may be connected to the frontside metals 112 through the signal IO via 400. The power via 300 may be connected to the power conductor 210 (see Fig. 2) in the backside metal 122 and the core 600 (see Fig. 2) positioned on the front surface 110.

Referring to FIG. 3F, a package process (e.g., a package bonding process) may be performed to complete a processing/fabrication of the system 1. For example, the package 800 may be bonded to a backside metal 122 at the backside 120 of the wafer 100 as part of the package bonding process. A system incorporating a signal IO via 400 (e.g., a signal IO via having a height or a width that is respectively larger than a height or a width of the power vias 300) may have an enhanced signal line resistance in comparison to a system incorporating a "small" signal via option.

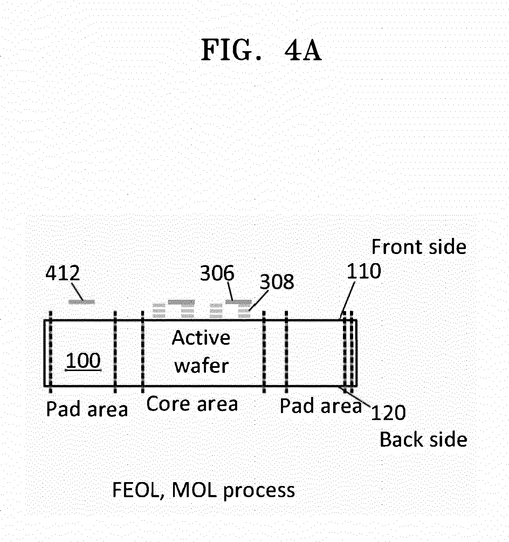

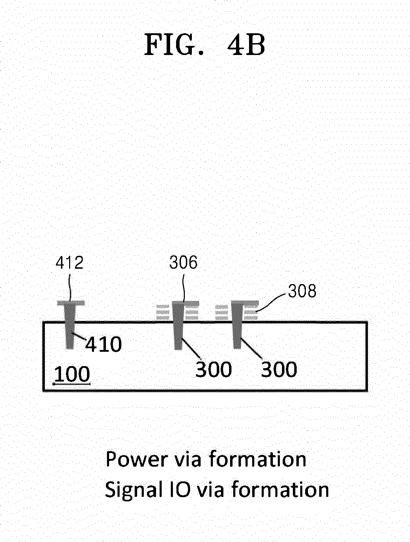

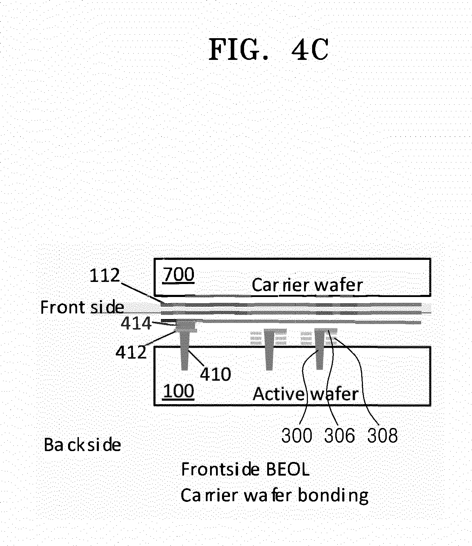

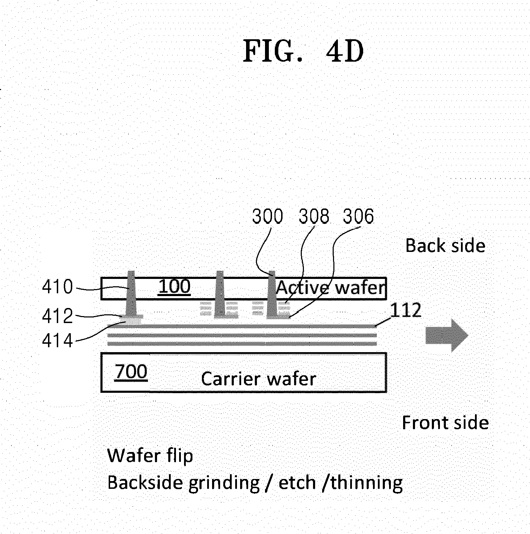

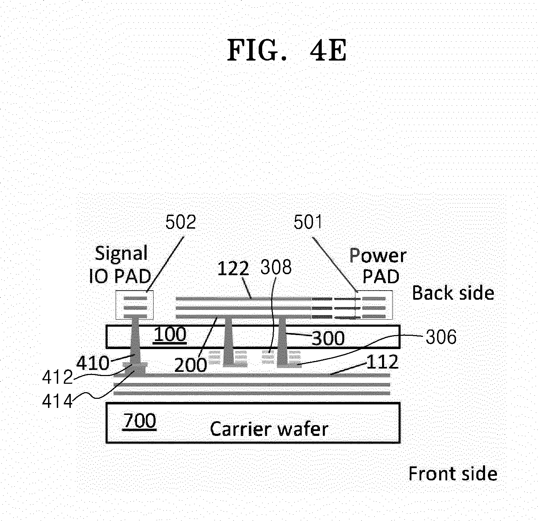

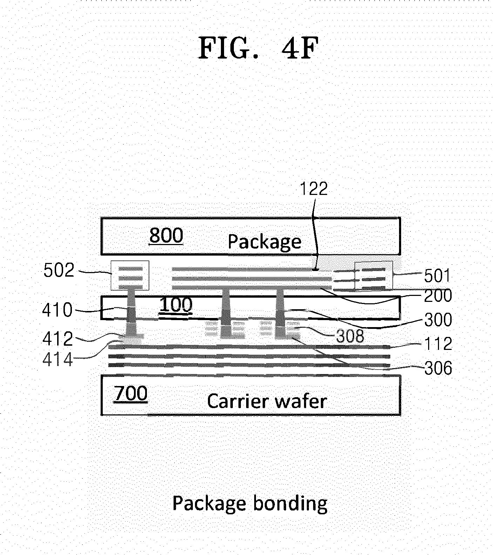

FIG. 4 (including FIGS. 4A to 4F) is a process diagram depicting operations of a method of manufacturing an integrated circuit with power via structures and signal via structures that are substantially the same as each other (e.g., "small" signal IO vias 410 are used instead of "large" signal IO vias 400), according to one or more embodiments of the present disclosure.

Referring to FIG. 4A, a wafer 100 may be positioned such that a frontside 110 of the wafer 100 is on top of, or above, a backside 120 of the wafer 100. A logic circuit 308 and a contact 306 may be built on, or formed on, the frontside 110 by performing a FEOL process and a MOL-contact process.

Referring to FIG. 4B, a power via 300 and a small signal IO via 410 may be built on, or formed on, the wafer 100 for respectively making power distribution network (PDN) connections and signal IO line connections at the frontside 110 and the backside 120. Accordingly, as compared to the embodiments corresponding to FIG. 3, the manufacturing process may be simplified in that the power via 300 and the signal IO via 400 may be built during the same operation.

Referring to FIG. 4C, frontside metals 112 may be formed at the frontside 110 by performing a BEOL process. Also, a contact 412 and a contact via 414 may be used with the small signal IO via 410 to connect the small signal IO via 410 to the frontside metals 112. Further, a carrier wafer 700 may be bonded above the frontside metals 112 above the wafer 100.

Referring to FIG. 4D, the carrier wafer 700 may be flipped to position the wafer 100 with the backside 120 on top of, or above, the frontside 110. The backside 120 of the wafer 100 may be prepared for further processing by performing a backside grinding, an etching, and/or a thinning process(es) to expose the power via 300 and the small signal IO via 410.

Referring to FIG. 4E, a backside BEOL/BSPDN/pad generation process may be performed. In one or more embodiments, the BSPDN and the pad areas may be formed as separate and distinct structures on the backside 120. In one or more embodiments, the BSPDN and the pad areas may be formed at a same level on the backside 120. For example (and as also shown in FIG. 2), a surface of the PDN 200 may be substantially co- planar with a surface of the pad areas 500. In one or more embodiments, backside metals 122 may be built on, or formed on, the backside 120, and such that connections may be made between the backside metals 122 and their respective vias. For example, a power pad in a pad area 500 on the backside 120 may be connected to the logic circuit 308 on the frontside 110 through the power via 300. Also, a signal IO pad in the pad area 500 may be connected to the frontside metals 112 via the small signal IO via 410.

Referring to FIG. 4F, a package process (e.g., a package bonding process) may be performed to complete a processing of the system 1. For example, the package 800 may be bonded to a backside metal 122 at the backside 120 of the wafer 100 as part of the package bonding process. A manufacturing process of the system 1 may be simplified according to the process of FIG. 4 as a result of using vias for the small signal IO vias 410 that are substantially the same as the power vias 300.

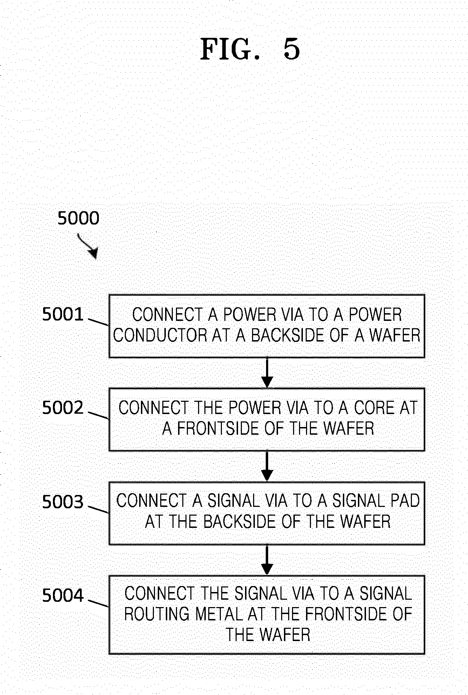

FIG. 5 is a flowchart depicting operations of a method of manufacturing an integrated circuit, according to one or more embodiments of the present disclosure.

Referring to FIG. 5, a method 5000 of manufacturing an IC may include one or more of the following operations. A power via 300 may be connected to a power conductor 210 at a backside 120 of a wafer 100 (e.g., backside metals 122 may be built on, or formed on, the backside 120, and such that connections may be made between the backside metals 122 and their respective vias, as discussed above with respect to FIGS. 3E and 4E) (operation 5001). The power via 300 may be connected to a core at the core area 600 at a frontside 110 of the wafer 100 (e.g., a power via 300 may be built on, or formed on, the wafer 100 for making power distribution network (PDN) connections at the frontside 110 and the backside 120, as discussed above with respect to FIGS. 3B and 4B) (operation 5002). A signal pad may be connected to a signal via (e.g., a signal IO via 400 or a small signal IO via 410) at the backside 120 of the wafer 100 (operation 5003). The signal via may be connected to a signal-routing metal of the frontside metals 112 at the frontside 110 of the wafer 100 (e.g., a signal IO pad in the pad area 500 may be connected to the frontside metals 112 through the signal IO via 400 or the small signal IO via 410, as discussed above with respect to FIGS. 3E and 4E) (operation 5004).

Accordingly, aspects of one or more embodiments of the present disclosure may provide advantages and improvements over conventional IC power and signal-routing schemes, such as reducing power and signal-routing congestion and simplifying PDN metals for improved resistance and reduced manufacturing costs.

While embodiments of the present disclosure have been particularly shown and described with reference to the embodiments described herein, it will be understood by those of ordinary skill in the art that various changes in form and details may be made therein without departing from the scope of the appended claims.

## Claims

1. A system (1) for routing connections to a logic circuit (308), the system (1) comprising:
a first wafer (100) having a backside (120) and a frontside (110) opposite the backside (120);
a power conductor (210) at the backside (120) of the first wafer (100);
a core (600) at the frontside (110) of the first wafer (100);
a power via (300) electrically connected to the power conductor (210) and to the core (600);
a signal pad (510) at the backside (120) of the first wafer (100);
a first frontside signal-routing metal (112a) at the frontside (110) of the first wafer (100); and
a signal via (400, 410) connected to the signal pad (510) and the first frontside signal-routing metal (112a).

2. The system (1) of claim 1, wherein a height or a width of the signal via (400, 410) is respectively larger than a height or a width of the power via (300).

3. The system (1) of claim 1, wherein the signal via (400, 410) has substantially a same size as the power via (300).

4. The system (1) of any one of claims 1 to 3, further comprising a second wafer (700) at the frontside (110) of the first wafer (100), and located above the core (600).

5. The system (1) of any one of claims 1 to 4, further comprising a package (800) at the backside (120) of the first wafer (100).

6. The system (1) of claim 5, further comprising a pad area (500) at the backside (120) of the first wafer (100).

7. The system (1) of claim 6, wherein the pad area (500) comprises:
a first pad area (501) comprising a supply voltage pad (550, 560) and a first signal pad (510); and
a second pad area (502) comprising a second signal pad (520).

8. The system (1) of claim 7, further comprising:
a power distribution network (200) at the backside (120) of the first wafer (100), and comprising the power conductor (210); and
a conductive path configured to route a supply voltage:
from the package (800) to the supply voltage pad (550, 560);
from the supply voltage pad (550, 560) to the power distribution network (200); and
from the power distribution network (200) to the core (600).

9. The system (1) of claim 7 or 8, further comprising a conductive path configured to route a signal:
from the package (800) to the first signal pad (510);
from the first signal pad (510) to the first frontside signal-routing metal (112a); and
from the first frontside signal-routing metal (112a) to the core (600).

10. The system (1) of any one of claims 7 to 9, further comprising a conductive path configured to route a signal:
from the core (600) to a second frontside signal-routing metal (112b);
from the second frontside signal-routing metal (112b) to the second signal pad (520); and
from the second signal pad (520) to the package (800).

11. A method of manufacturing an integrated circuit, the method comprising:
connecting a power via (300) to a power conductor (210) at a backside (120) of a first wafer (100), and to a core (600) at a frontside of the first wafer (100); and
connecting a signal via (400, 410) to a signal pad (510, 520) at the backside (120) of the first wafer (100), and to a signal-routing metal (112a, 112b) at the frontside (110) of the first wafer (100).

12. The method of claim 11, further comprising forming the signal via (400, 410) on the first wafer (100) to have a height or a width that is respectively larger than a height or a width of the power via (300).

13. The method of claim 11, further comprising forming the signal via (400, 410) on the first wafer (100) to have substantially a same size as the power via (300).

14. The method of any one of claims 11 to 13, further comprising bonding a second wafer (700) above a frontside metal (112) at the frontside (110) of the first wafer (100).

15. The method of any one of claims 11 to 14, further comprising:
flipping the first wafer (100) to position the backside (120) of the first wafer (100) above the frontside (110) of the first wafer (100); and
building a pad area (500) at the backside (120) of the first wafer (100).

16. The method of claim 15, further comprising building a supply voltage pad (550, 560) and the signal pad (510, 520) in the pad area (500).

17. The method of claim 16, further comprising:
connecting the supply voltage pad (550, 560) to a power distribution network (200) at the backside (120) of the first wafer (100), the power distribution network (200) comprising the power conductor (210).

18. The method of any one of claims 11 to 17, further comprising bonding a package (800) to a backside metal (122) at the backside (120) of the first wafer (100).

19. The method of claim 18, wherein the backside metal (122) is connected to a supply voltage pad (550, 560) or a signal pad at the backside (120) of the first wafer (100).
